# EUROPEAN PATENT APPLICATION

(11) **EP 4 766 055 A2**
(43) Date of publication of application: **24.06.2026**
(21) Application number: 25213933.2
(22) Date of filing: 06.11.2025
(51) Int. Cl.: H05K 7/20

(54) **LIQUID-BASED COOLING SYSTEMS FOR HIGH-CAPACITY POWER MANAGEMENT SYSTEMS**

(30) Priority: 02.12.2024 US 202418965030
(71) Applicant: Eaton Intelligent Power Limited, Dublin D04 Y0C2 (IE)
(72) Inventor: Verma, Manoj Kumar, Pune (IN); Kittur, Avadhoot, Pune (IN); Caulfield, Francis Donald, Raleigh (US); Salutagi, Shivayogi Sidram, Pune (IN)
(74) Representative: Schwan Schorer & Partner mbB

(57) **Abstract**

A thermal management system for uninterruptible power supplies (UPS) is disclosed. The thermal management system can include a plurality of power modules and a cooling assembly operatively coupled to the power modules. The cooling assembly can include a cold plate cooling arrangement configured to circulate a cooling fluid through cold plates in thermal contact with the power modules. The cooling assembly can include a single-phase immersion cooling arrangement configured to submerge the power modules in a dielectric fluid for direct contact with the power modules. The cooling assembly can include a two-phase immersion cooling arrangement configured to immerse the power modules in a dielectric liquid that transitions from liquid to vapor upon heat absorption, with subsequent condensation and recirculation of the dielectric liquid. The system can be configured to accommodate various power densities and UPS configurations.

## Description

### FIELD

The present disclosure generally relates to thermal management in uninterruptible power supplies (UPS), and more particularly, to liquid-based cooling systems.

### BACKGROUND

High-capacity power management systems, including uninterruptible power supplies (UPS), can be deployed in a range of environments, such as data centers and industrial facilities, to maintain power continuity during outages. As these systems are designed to support increasing power capacities, they often incorporate a higher number of power modules in a tightly packed arrangement within the unit. This dense configuration can generate substantial heat, which presents a challenge for thermal management. Traditional air-cooled systems, typically using fans or blowers, have been the standard for dissipating this heat. However, as power densities rise, these systems may reach their limits in effective heat removal, potentially resulting in higher energy usage and an increased risk of overheating.

Under high-capacity operating conditions, air-cooled systems may also exhibit inconsistent thermal performance, which can contribute to accelerated component wear, reduced energy efficiency, and a heightened risk of overheating, especially during peak loads. As UPS and other high-capacity power management systems evolve to feature more densely packed power modules and increased power handling capabilities, more advanced and adaptable cooling solutions are needed to provide effective thermal management across diverse power configurations and environmental conditions.

### SUMMARY

Embodiments of the present disclosure provide advanced liquid cooling systems for uninterruptible power supplies (UPS), which can improve thermal management and increase power density. Some aspects of the inventive concept include three distinct liquid-based cooling methods: cold plate cooling, single-phase immersion cooling, and two-phase immersion cooling. The cold plate cooling system circulates a cooling fluid through channels in plates that directly contact power modules. The single-phase immersion system submerges power modules in a dielectric fluid for direct heat transfer. The two-phase immersion system uses a dielectric liquid that vaporizes upon heat absorption, allowing efficient thermal regulation through phase change. These systems can support higher power densities and greater UPS capacities compared to traditional air-cooled systems.

Certain illustrative examples are described in the following numbered clauses:
Clause 1. A cooling system for a high-density power supply system, the cooling system comprising:
   a cooling flow path comprising a plurality of columns configured to hold and circulate a dielectric working fluid in a liquid phase;
   a plurality of power modules, each power module comprising a heat-generating region and a control interface portion, wherein the heat-generating regions of the power modules are positioned on opposing sides of each column and directly face the dielectric working fluid within the columns;
   a vapor space positioned above the cooling flow path; and
   a condenser in thermal communication with the vapor space,
   wherein the dielectric working fluid in the cooling flow path absorbs heat from the heat-generating regions of the power modules and transitions from the liquid phase to a vapor phase, wherein vaporized dielectric working fluid rises from the cooling flow path into the vapor space, and the condenser condenses the vaporized dielectric working fluid back into the liquid phase and returns condensed fluid to the cooling flow path.
Clause 2. The cooling system of clause 1, wherein each column includes an internal channel structure configured to guide a flow of the dielectric working fluid within the column.
Clause 3. The cooling system any of the preceding clauses, wherein the power modules are arranged in a stacked configuration along each column, with the heat-generating regions of the power modules aligned in a vertical series on opposing sides of the cooling flow path.
Clause 4. The cooling system any of the preceding clauses, wherein each power module is configured without insulation layers on the heat-generating region, allowing for direct thermal contact between the heat-generating region and the dielectric working fluid within each column.
Clause 5. The cooling system any of the preceding clauses, further comprising a header structure proximate a top of each column, configured to channel vaporized dielectric working fluid from multiple columns into the condenser.
Clause 6. The cooling system any of the preceding clauses, wherein each column comprises an internal cooling volume configured to hold the dielectric working fluid, with the heat-generating regions of the power modules positioned on external surfaces of the column and thermally coupled to the dielectric working fluid within the internal cooling volume.
Clause 7. The cooling system of clause 6, wherein the power modules are mounted along opposing outer surfaces of each column, with the heat-generating regions of the power modules aligned to transfer heat through walls of the column to the dielectric working fluid contained within the internal cooling volume.
Clause 8. The cooling system any of the preceding clauses, wherein the columns are substantially vertically oriented.
Clause 9. The cooling system any of the preceding clauses, wherein the high-density power supply system comprises an uninterruptible power supply (UPS) system.
Clause 10. A cooling system for a high-density power supply system, the cooling system comprising:
   a cold plate having a fluid inlet and a fluid outlet, the cold plate defining an internal fluid channel configured to circulate a dielectric working fluid;
   a plurality of power modules, each power module comprising a heat-generating region and a control interface portion, wherein the heat-generating regions of the power modules are mounted along opposing outer surfaces of the cold plate, with the heat-generating regions aligned to transfer heat through walls of the cold plate to the dielectric working fluid within the internal fluid channel;
   a heat exchanger in fluid communication with the working fluid outlet and the working fluid inlet of the cold plate, configured to dissipate heat absorbed by the dielectric working fluid as it circulates through the heat exchanger and returns to the cold plate.
Clause 11. The cooling system of clause 10, wherein the dielectric working fluid comprises a mixture of water and ethylene glycol (EGW).
Clause 12. The cooling system of clause 10, wherein the cold plate is positioned in a horizontal orientation and defines a substantially horizontal flow path for the dielectric working fluid, the cold plate comprising a fluid inlet positioned on one side of the cold plate and a fluid outlet positioned on an opposite side of the cold plate, such that the dielectric working fluid flows laterally across an internal channel of the cold plate in a substantially horizontal direction.
Clause 13. The cooling system of clause 12, wherein power modules are mounted on upper and lower external surfaces of the cold plate, with the heat-generating regions of the power modules in thermal communication with the dielectric working fluid flowing through the cold plate.
Clause 14. The cooling system of clause 10, wherein the cold plate comprises a plurality of individual cold plates arranged in a stacked configuration, each individual cold plate in fluid communication with a common fluid inlet manifold and a common fluid outlet manifold, and wherein power modules are mounted on opposing external surfaces of each individual cold plate, with the heat-generating regions of the power modules in thermal communication with the dielectric working fluid flowing through each cold plate.
Clause 15. The cooling system of clause 10, wherein the high-density power supply system comprises an uninterruptible power supply (UPS) system.
Clause 16. A cooling system for a high-density power supply system, the cooling system comprising:
   a cooling flow path configured to hold and circulate a working fluid to manage a thermal load generated by the power supply system during operation; and
   a plurality of power modules, each power module comprising a heat-generating region and a control interface portion, wherein the heat-generating regions of the power modules are mounted on opposing exterior surfaces of the cooling flow path and directly face the cooling flow path, such that each heat-generating region is in thermal communication with the working fluid within the cooling flow path.
Clause 17. The cooling system of clause 16, wherein the high-density power supply system comprises an uninterruptible power supply (UPS) system.

### BRIEF DESCRIPTION OF THE DRAWINGS

Throughout the drawings, reference numbers can be re-used to indicate correspondence between referenced elements. The drawings are provided to illustrate embodiments of the present disclosure and do not to limit the scope thereof.
FIG. 1 illustrates an embodiment of a cooling system for a high-density power supply system.
FIG. 2A illustrates an embodiment of a power module cold plate system implementing a cooling flow path that includes a cold plate to manage thermal loads in a high-density power configuration.
FIG. 2B illustrates an alternative embodiment of a power module cold plate system using a cold plate to manage thermal loads in a high-density power configuration, similar to the configuration shown in FIG. 2A.
FIG. 3 illustrates an embodiment of a cooling system configured to manage thermal loads in a high-density power supply system.
FIG. 4A illustrates an embodiment of a cooling system, where power module cold plate systems are arranged in a stacked configuration.
FIG. 4B illustrates a side view of the cooling system of FIG. 4A.
FIG. 4C illustrates an example of a cross section of a cold plate.
FIG. 5 illustrates an embodiment of a two-phase cooling system for managing thermal loads in a high-density power configuration.
FIGS. 6A and 6B illustrate side and three-dimensional perspective views, respectively, of an embodiment of a two-phase cooling system designed to manage thermal loads within a high-density power configuration.
FIG. 7A illustrates example total UPS power capacities achieved through various cooling configurations.
FIG. 7B demonstrates example improvements in UPS power density for different cooling methods.

### DETAILED DESCRIPTION

Managing thermal loads in high-capacity power management systems, including uninterruptible power supplies (UPS), can improve system performance in environments such as data centers and industrial facilities. Traditional air-cooled solutions, often relying on fans or blowers, have been widely used to manage heat generated by densely packed power modules. However, as demand for higher power densities increases, air cooling approaches may encounter limitations that affect thermal efficiency and overall system reliability. These limitations suggest a need for adaptable cooling methods that support dense thermal loads while maintaining energy efficiency.

Some inventive concepts described herein relate to liquid-based cooling architectures that address limitations of air-cooled or other designs. In some configurations, a cooling system can include a cooling flow path designed to circulate a working fluid for thermal management. Further, the cooling system can include power modules that are designed such that major heat-generating components, such as power transistors, capacitors, and inductors, are consolidated into a dedicated heat-generating region. The heat-generating regions can be mounted along the cooling flow path, with each heat-generating region directly facing the working fluid. The configuration can place the heat-generating regions in thermal communication with the working fluid, facilitating efficient heat transfer. The liquid-based cooling architecture can support higher power densities and compact configurations while addressing limitations associated with traditional air-cooled systems.

Some inventive concepts described herein relate to cooling systems that include a cooling flow path implemented with channels configured to hold and circulate a working fluid adjacent to the power modules. The channels can allow the working fluid to absorb heat from the power modules without fully submerging the power modules, which can reduce the volume of fluid required. This design can also prevent the power modules from being directly exposed to the working fluid, simplifying system integration and reducing a likelihood of potential issues associated with fluid exposure. By utilizing a channel-based cooling flow path, a cooling system can achieve the heat exchange of liquid cooling, such as efficient heat dissipation and higher power densities, while addressing challenges related to fluid management and maintenance.

Some inventive concepts described herein relate to cooling systems that include one or more cooling plates configured to circulate a working fluid for thermal management. In some configurations, a cooling plate can include internal channels that allow a dielectric or other cooling fluid to flow through, absorbing heat from power modules positioned in thermal communication with the cooling plate. In some cases, heat-generating regions of the power modules can be placed in direct thermal communication with the cooling plate, facilitating effective heat transfer without requiring full submersion of the modules in the cooling fluid. A cooling plate configuration can provide a compact and efficient solution for managing high thermal loads, supporting increased power densities in high-capacity power systems while maintaining consistent temperature control.

Some inventive concepts described herein relate to cooling systems that employ two- or multi-phase cooling techniques to provide thermal management capabilities. In some embodiments, a cooling flow path can hold and circulate a working fluid through separate channels or pathways. The heat-generating regions of power modules can be mounted on opposing exterior surfaces of the cooling flow path, positioning heat-generating regions in thermal communication with the working fluid. As the working fluid absorbs heat from the power modules, the working fluid can transition from a liquid to a vapor phase, rising to a condenser where it returns to a liquid form and recirculates through the cooling flow path. This configuration can establish a continuous cycle of heat removal and supports effective thermal management for high-density power systems. In some cases, such a cooling system can support higher thermal loads by reducing reliance on active cooling components, such as fans, that may contribute to lower noise and energy consumption.

Some inventive concepts may represent advancements in thermal management for high-capacity power management systems. By incorporating liquid-based and/or two-phase cooling techniques, these concepts can improve thermal performance and adaptability across various operating conditions. The disclosed techniques may offer potential benefits for UPS and other high-capacity power systems, supporting effective thermal regulation in densely packed configurations and across diverse environments.

Some inventive concepts described herein can be directed to a liquid cooling architecture for uninterruptible power supplies (UPS), which can provide significant improvements in thermal management and power density. This architecture incorporates cooling systems tailored for UPS configurations, including cold plate cooling, single-phase cooling, and/or two-phase cooling. A cold plate system can utilize ethylene glycol (EGW) fluid circulated through cold plates thermally interfaced with power modules, potentially increasing power density by approximately 1.2x in some configurations. A single-phase cooling system can employ a dielectric fluid in thermal contact with power module surfaces, reducing thermal resistance by removing intermediate insulation layers, with examples demonstrating reductions of up to 90%. This configuration may achieve improvements such as a twofold increase in power density and support UPS capacities in the range of several megawatts, including up to 3 MW in specific implementations. A two-phase system can use Novec 7200 dielectric liquid to enable phase-change cooling, where the fluid vaporizes upon heat absorption, demonstrating potential power density increases of up to 2.5x and supporting UPS capacities of several megawatts, such as up to 4.5 MW in some implementations.

### Example Cooling System

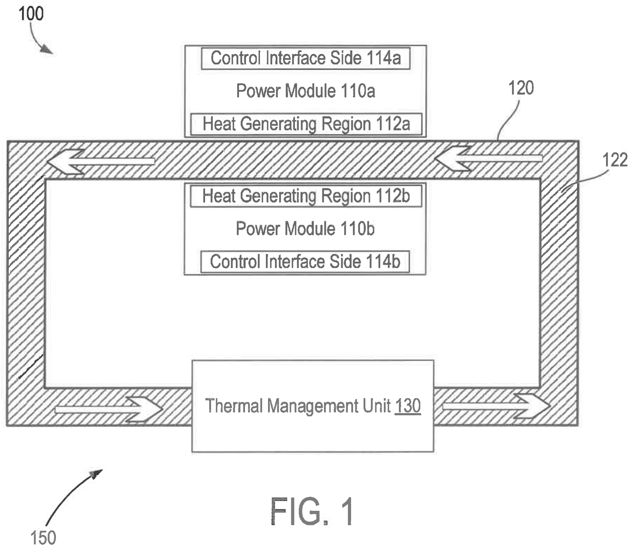

FIG. 1 illustrates an embodiment of a cooling system 100 for a high-density power supply system. In this example, the cooling system 100 includes a cooling flow path 120 configured to hold and circulate a working fluid 122 to manage thermal loads generated, at least in part, by a plurality of power modules 110a, 110b (individually or collectively referred to as power modules 110 or power module 110) during operation. The cooling flow path 120 can provide a pathway for the working fluid 122 to flow proximate the power modules 110, allowing for efficient heat transfer.

The power supply system (not shown) can be implemented in various high-density power applications, including, but not limited to, data centers and industrial facilities. In some cases, the power supply system can be an Uninterruptible Power Supply (UPS) system. In some cases, the power supply system can be configured to provide stable power delivery to connected loads, maintaining consistent power regulation and system reliability, even during fluctuations or interruptions in a primary power source.

A power module 110 may be configured to perform various functions related to power regulation, monitoring, and/or protection within the power supply system. For example, a power module 110 can regulate power output, manage charging cycles of backup batteries, monitor operational parameters, or detect potential faults. In some cases, the power module 110 can communicate status and diagnostics to external systems, supporting ongoing monitoring and maintenance of the power supply system.

Each power module 110 can include various components arranged to facilitate thermal management and functional organization. In some configurations, the power module 110 can utilize a design where major heat-generating components, such as power transistors, capacitors, and inductors, are consolidated into a heat-generating region 112a, 112b (individually or collectively referred to as heat-generating region 112). The determination of which components are included in the heat-generating region can be based on objective factors such as thermal output, operating power levels, or energy dissipation characteristics during typical operation.

Consolidating the heat-generating components into a specific region can provide several advantages. It can allow for targeted thermal management, where cooling resources are concentrated on areas with the highest thermal output, reducing the need for system-wide heat dissipation measures. This design can also simplify thermal modeling and improve overall cooling efficiency by limiting the variability of heat distribution across the module.

In some configurations, the heat-generating components can be confined to one side of the power module, with substantially non-heat-generating components, such as control circuitry, signal connections, or monitoring elements, positioned on an opposing side, referred to as the control interface portion 114a, 114b (individually or collectively referred to as control interface portion 114). Alternatively, heat-generating and non-heat-generating components can be positioned on the same side of the power module but separated into distinct areas to generally maintain spatial or thermal isolation. Other layouts can include, but are not limited to, heat-generating components being grouped near the center of the power module 110, with non-heat-generating components arranged along the periphery. In another example, components can be positioned on opposing corners or sides of the same face to further separate regions of high and low thermal output.

As shown in FIG. 1, in some cases, the power modules 110 can be arranged with the heat-generating region 112 positioned adjacent to the cooling flow path 120, while the control interface portion 114 is oriented away from the cooling flow path. This arrangement allows cooling resources to be concentrated on areas with the highest thermal output, enabling efficient thermal management of the heat-generating components. By consolidating these components on one side of each power module, the design can facilitate a more compact arrangement of power modules around the cooling flow path and reduce the need for cooling resources in other areas.

In some configurations, the control interface portion 114 may not require dedicated cooling, as it is positioned away from the primary heat transfer zone. This separation can support dense packing of power modules while maintaining effective heat dissipation. By aligning the cooling flow path in direct thermal communication with the heat-generating region 112, the configuration can improve thermal management efficiency where it is most needed, while reducing thermal exposure to the control interface portion 114 to preserve its functionality in high-density environments.

The cooling flow path 120 can include one or more pathways within the cooling system 100, designed to circulate the working fluid 122 that absorbs and removes heat from the power modules 110. By routing the working fluid 122 along pathways adjacent to the heat-generating regions 112 of the power modules 110, the cooling flow path 120 manages thermal loads in high-density power configurations. This design facilitates efficient heat exchange between the heat-generating regions 112 and the working fluid 122, helping to maintain stable operating temperatures and ensuring reliable system performance.

The cooling flow path 120 can be implemented in various structural configurations based on the cooling requirements and spatial arrangement of the power modules 110. In some cases, the cooling flow path 120 can be enclosed, allowing the working fluid 122 to circulate without directly contacting the power modules 110. This enclosed configuration can isolate the working fluid 122 while still enabling effective heat transfer through thermal coupling with the heat-generating regions 112. In some cases, the cooling flow path 120 can include a plurality of channels, which may be configured as generally horizontal channels, vertical columns, or angled pathways to accommodate the layout of the fluid distribution throughout the system. In some cases, the cooling flow path 120 can include one or more cold plate, as described herein.

The arrangement of power modules 110 along or about the cooling flow path 120 can involve positioning power modules 110 on different sides of the cooling flow path 120, with the heat-generating regions 112 on each power module 110 facing the cooling flow path 120. This arrangement can allow two or more power modules 110 to use the same general portion of the cooling flow path 120 for thermal management from multiple sides. For example, power modules 110 can be stacked side by side along one side of the cooling flow path 120, creating a series of heat-generating regions 112 in direct thermal communication with the cooling flow path 120. Additional power modules 110 can also be positioned on another side (e.g., an adjacent side, an opposite side) of the cooling flow path, either aligned with or offset from (e.g., diagonal from) the power modules 110 on the first side. In some cases, two, three, four or more power modules 110 can share a single segment of the cooling flow path. For example, two power modules 110 can be positioned on one side, stacked vertically, while another power module 110 or two are placed on the opposite side, aligned or staggered relative to the first set. Such arrangements allows multiple power modules 110 to efficiently share the cooling capacity of the same section of the cooling flow path 120, leveraging its surface area for effective thermal communication and supporting compact, high-density system configurations.

The cooling flow path 120 is a pathway within the cooling system configured to circulate a working fluid that absorbs and transfers heat away from the power modules 110. By directing the working fluid along routes adjacent to the heat-generating regions 112 of the power modules, the cooling flow path 120 supports the management of thermal loads in high-density power configurations. This pathway is designed to facilitate heat exchange between the power modules and the circulating fluid, helping to maintain stable operating temperatures.

The working fluid 122 within the cooling flow path 120 can be selected to support efficient thermal transfer and compatibility with the system components. In some cases, the working fluid 122 may be a dielectric fluid, which can facilitate thermal contact with the heat-generating regions of the power modules 110 without affecting electrical functionality. The working fluid 122 can flow through various channels and pathways in the cooling flow path 120, absorbing heat as it moves adjacent to heat-generating components. The working fluid 122 may be a blend, such as a mixture of water and ethylene glycol (EGW), or another suitable coolant based on the system's thermal requirements. In some cases, the working fluid 122 circulates from a fluid inlet of the cooling flow path 120, flows along the heat-generating regions 112 of the power modules, and is directed toward the thermal management unit 130 for heat dissipation.

The thermal management unit 130 can be in fluid communication with the cooling flow path 120 and can be configured to dissipate the heat absorbed by the working fluid 122 as it circulates through the cooling system 100. In some cases, the cooling flow path 120 is in fluid communication with the thermal management unit 130 to facilitate continuous heat dissipation and fluid recirculation. In some cases, the thermal management unit 130 may function as a heat exchanger, transferring thermal energy from the working fluid to the external environment, allowing the working fluid to cool before it recirculates back through the cooling flow path 120. This continuous cycle of heat absorption and dissipation supports stable temperature regulation for high-density power configurations.

The thermal management unit 130 can be implemented in various forms, depending on the cooling needs and design of the cooling system 100. For example, the thermal management unit 130 may include a radiator to release heat from the working fluid into the surrounding air or a condenser to facilitate phase change cooling in two-phase configurations. In some embodiments, the thermal management unit 130 may be configured as a liquid-to-air or liquid-to-liquid heat exchanger, tailored to the specific heat dissipation requirements of the cooling system.

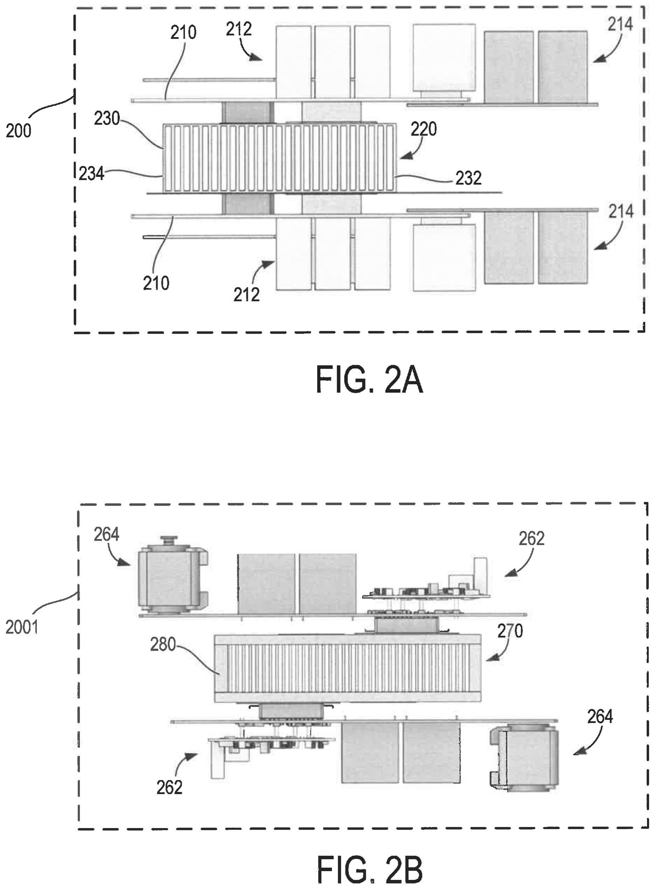

FIG. 2A illustrates an embodiment of a power module cold plate system 200 implementing a cooling flow path that includes a cold plate 230 to manage thermal loads in a high-density power configuration. In this example, the power module cold plate system 200 includes a plurality of power modules 210, each having a heat-generating region 212 and a generally non-heat generating region 214. The heat-generating region 212 of each power module 210 is thermally coupled to (e.g., faces) the cold plate 230, allowing heat to transfer from the heat-generating region 212 of the power modules to the cold plate 230.

The cold plate 230 is configured with an internal fluid flow path 220, allowing a working fluid to flow through and absorb heat from the heat-generating regions 212 of the power modules 210. The cold plate 230 includes a fluid inlet 232 and a fluid outlet 234, facilitating the entry and exit of the working fluid as it moves through the cold plate 230. In some cases, the internal fluid flow path 220 may include fins to increase the surface area for heat transfer, enhancing the cooling efficiency of the cold plate 230. In some embodiments, the cold plate 230 may be implemented without fins. The working fluid, which can be a dielectric fluid such as a mixture of water and ethylene glycol (EGW), flows through the internal fluid flow path 220, absorbing heat from the cold plate 230 as it passes through.

In some cases, the cold plate 230 is oriented generally horizontally, with the working fluid inlet 232 on one side and the working fluid outlet 234 on the opposite side, facilitating lateral flow of the working fluid across the internal channel. In some cases, the cold plate 230 is oriented generally vertically, allowing the working fluid to flow from a lower inlet 232 to an upper outlet 234, leveraging gravity-assisted flow. In some cases, the cold plate 230 is positioned at an angle, enabling diagonal flow of the working fluid, which may facilitate fluid distribution or thermal interaction based on the system's layout.

As shown, multiple power modules 210 can be positioned on a common cold plate 230. Although the example illustrates two power modules, additional modules can also be accommodated depending on the design. This dual- or multi-mount arrangement enables a more compact and high-density configuration. In some cases, this arrangement can increase power density by approximately 1.2 to 1.5 times, or more, compared to similarly rated air-cooled systems. At least part of this power density improvement can be attributed to the use of multiple sides of the cold plate 230 for heat dissipation, allowing more efficient utilization of the cooling surface area.

After flowing through the cold plate 230, the heated working fluid can be directed to an external thermal management unit (such as thermal management unit 130), such as a radiator or heat exchanger which dissipates the absorbed heat into the surrounding environment. The thermal management unit can be in fluid communication with both the working fluid outlet and inlet of the cold plate, allowing the working fluid to cool before it re-enters the cold plate 230, thereby maintaining a cycle of heat transfer.

FIG. 2B illustrates an alternative embodiment of a power module cold plate system 201 using a cold plate 280 to manage thermal loads in a high-density power configuration, similar to the configuration shown in FIG. 2A. The power module cold plate system 201 can be an embodiment of the power module cold plate system 200 of FIG. 2A. In this embodiment, the power module cold plate system 201 includes a plurality of power modules 214, each having a heat-generating region 262 and a generally non-heat generating region 264, positioned adjacent to the cold plate 280. The cold plate 280 includes an internal fluid flow path 270 that allows a working fluid to flow through it, absorbing heat from the heat-generating regions of the power modules.

Unlike FIG. 2A, this embodiment shows a different arrangement for the generally non-heat generating region 264. The generally non-heat generating region 264 may include components such as monitoring or control circuitry, which may be positioned at various locations around the cold plate 280 as shown in FIG. 2B. Despite the alternative arrangement of control modules, the general function of the power module cold plate system 201 remains the same, with the working fluid entering and exiting through an inlet and outlet on the cold plate 280, allowing for efficient thermal management in high-density power applications.

As in FIG. 2A, the working fluid exits the cold plate 280 and can be directed to an external thermal management unit (not shown), such as a radiator or heat exchanger, to dissipate the absorbed heat. This configuration provides flexibility in positioning the generally non-heat generating region 264 while maintaining effective cooling of the heat-generating regions 262 of the power modules 214.

As shown, the heat-generating region 262 and the non-heat-generating region 264 of each power module 260 are positioned on the same face of the power module 260 but on distinct sides. Further, only the heat-generating region is coupled to the cold plate 280. This configuration allows for effective heat dissipation.

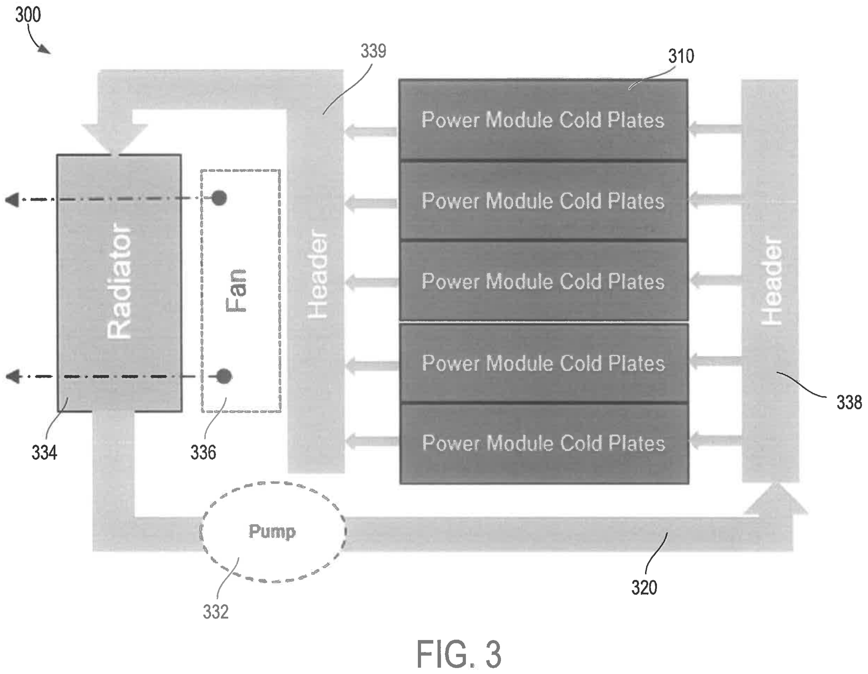

FIG. 3 illustrates an embodiment of a cooling system 300 configured to manage thermal loads in a high-density power supply system. The cooling system 300 can be an embodiment of the cooling system 100 of FIG. 1. In this example, the cooling system 300 includes a series of power module cold plate systems 310, arranged in a stacked configuration. Each power module cold plate system 310 can be an embodiment of the power module cold plate system 200 or 201 of FIGS. 2A and 2B, respectively. As described herein, each power module cold plate system 310 can be configured to thermally couple with the power modules. The cooling system 300 facilitates the circulation of a working fluid to absorb and transfer heat away from the power modules, supporting temperature management in high-density power applications.

The cooling system 300 includes a fluid flow path 320 that circulates the working fluid continuously through the components of the system. For example, the pump 332 can facilitate propulsion of the working fluid through the cooling system 300, directing the working fluid to an inlet header 338. The inlet header 338 distributes the working fluid to each power module cold plate system 310. In some cases, this setup can help to maintain uniform cooling throughout the cooling system 300, as each power module cold plate system 310 receives a controlled flow of working fluid that thermally contacts the heat-generating surfaces.

After the working fluid passes through the power module cold plate systems 310 and absorbs heat, the working fluid exits via an outlet header 339. The heated working fluid is then directed to a radiator 334, where it releases the absorbed heat into the surrounding environment. The radiator 334 can operate in conjunction with a fan 336, which promotes airflow across the radiator surface, improving the rate of heat dissipation. This combination of the radiator 334 and fan 336 can support thermal management by quickly dissipating heat from the working fluid.

Once cooled by the radiator 334, the working fluid is returned to the pump 332 to repeat the cycle, facilitating continuous cooling for the power module cold plate systems 310. This closed-loop fluid path 320 can allow the cooling system 300 to maintain stable operating temperatures for the power module cold plate systems 310, supporting effective thermal regulation in high-density configurations.

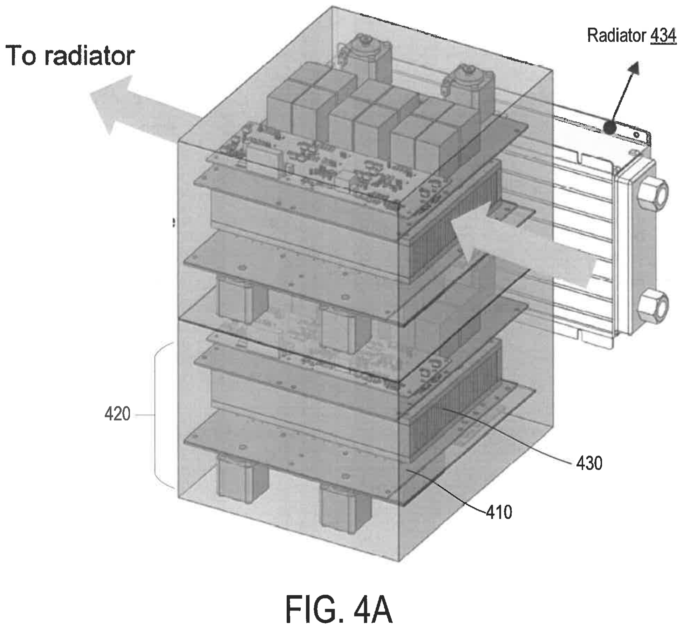

FIG. 4A illustrates an embodiment of a cooling system 401, where power module cold plate systems 420 are arranged in a stacked configuration. The cooling system 401 can be an embodiment of the cooling systems 100 or 300 of FIGS. 1 or 3, respectively. As described herein, each power module 410 can be thermally coupled to a cold plate 430. The cold plate 430 is configured to circulate a working fluid through internal channels, enabling heat transfer from the heat-generating regions of the power modules 410 to the working fluid. The heated working fluid exits the cold plate 430 and is directed to a radiator 434, where heat is dissipated into the surrounding environment. This stacked configuration of the power module cold plate systems 420 allows for compact, high-density thermal management.

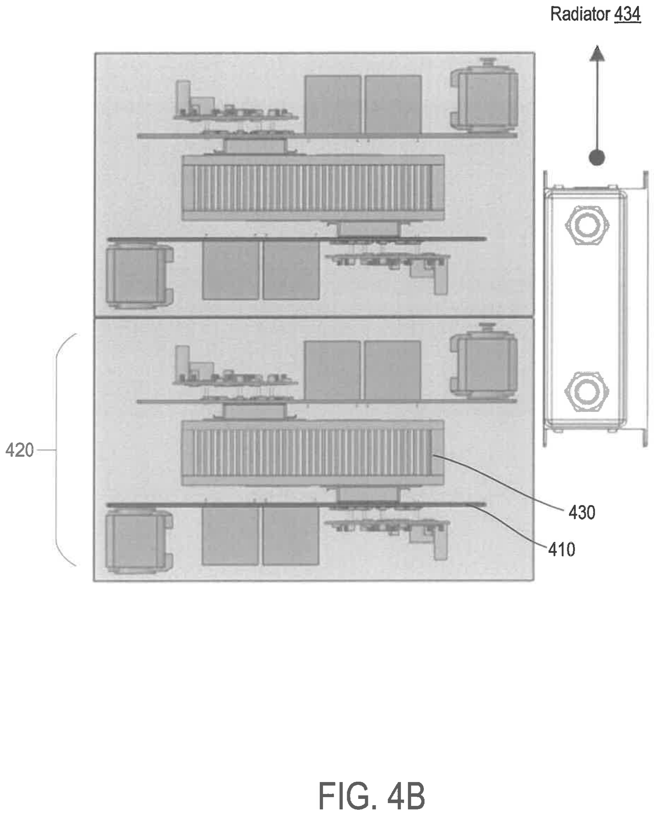

FIG. 4B illustrates a side view of the cooling system 401 of FIG. 4A. The system 401 includes multiple power modules 410, each thermally coupled to a corresponding cold plate 430. The cold plate 430 facilitates the flow of working fluid from an inlet to the radiator 434, where heat absorbed from the power modules 410 is dissipated into the surrounding environment.

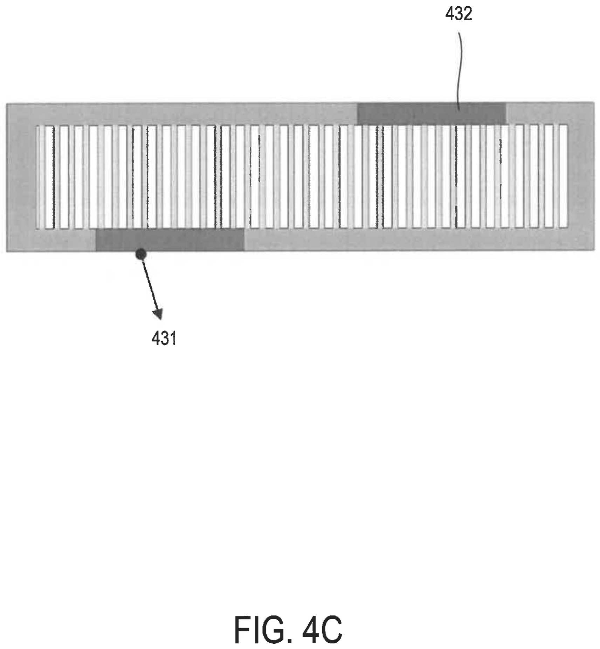

FIG. 4C illustrates an example of a cross section of a cold plate 430. The cold plate 430 is part of the power module cold plate system 420 and includes designated coupling regions 431, 432 configured to thermally interface with the heat-generating regions of the power modules 410. These identified areas on the cold plate 430 indicate where the heat-generating regions of the power modules 410 can directly contact the cold plate for thermal communication.

### Example Two-Phase Cooling System

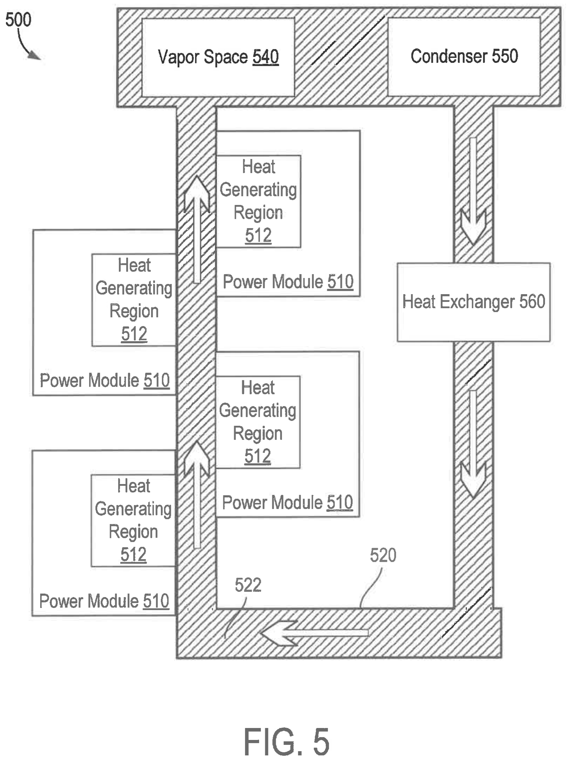

FIG. 5 illustrates an embodiment of a two-phase cooling system 500 for managing thermal loads in a high-density power configuration. The cooling system 500 can be an embodiment of the cooling systems 100, 300, 400, or 401 of FIGS. 1, 3, 4A or 4B, respectively. In this example, the cooling system 500 includes a plurality of power modules 510, each having a heat-generating region 512. In some embodiments, the power modules 510 may be replaced with a power module cold plate system, such as the power module cold plate systems 200 or 201 of FIGS. 2A and 2B, respectively. The power modules 510 are arranged proximate a cooling flow path 520, which is configured to circulate a working fluid to absorb and dissipate heat from the heat-generating regions 512.

The cooling flow path 520 includes a dielectric working fluid that absorbs heat from the heat-generating regions 512 of the power modules 510. In some cases, as the working fluid absorbs heat, it can transition from a liquid phase to a vapor phase. This vaporized working fluid then rises from the cooling flow path 520 into a vapor space 540 positioned above the power modules 510.

Positioned adjacent to the vapor space 540 is a condenser 550, which is in thermal communication with the vapor space. The vaporized working fluid enters the condenser 550, where it is cooled and condenses back into a liquid phase. The condensed working fluid then returns to the cooling flow path 520, maintaining a continuous cycle of heat absorption, vaporization, condensation, and recirculation.

In some configurations, the cooling flow path 520 may include an internal channel 522 to guide the flow of the working fluid, allowing efficient heat transfer between the power modules 510 and the working fluid. Such as enclosed design can advantageously facilitate thermal management by isolating the working fluid within defined pathways, directing heat transfer primarily to the heat-generating regions 512. In some cases, at least a portion of the power modules 510 may be disposed within the cooling flow path 520 such that the working fluid directly contacts the power modules 510.

In some cases, a vertical orientation of the cooling flow path, combined with the confined design of the cooling channels, reduces the volume of dielectric working fluid required for effective thermal management. This efficient use of two-phase fluid can reduce coolant volume while maintaining high thermal performance. The confined vertical volumes allow the fluid to vaporize and condense within a controlled space, enabling precise thermal regulation and reducing the system's overall coolant requirements. Such a design not only enhances system compactness but also lowers maintenance complexity and operational costs associated with managing large fluid volumes.

The cooling system 500 can include a heat exchanger 560 in fluid communication with the condenser 550. The heat exchanger 560 may dissipate residual heat from the working fluid before it re-enters the cooling flow path 520. This setup allows the working fluid to return to the cooling flow path 520 in a cooled state, ready to absorb additional heat from the power modules 510. By allowing the working fluid to transition between liquid and vapor phases, the cooling system 500 advantageously dissipates heat from the power modules 510, supporting stable operation under high thermal loads.

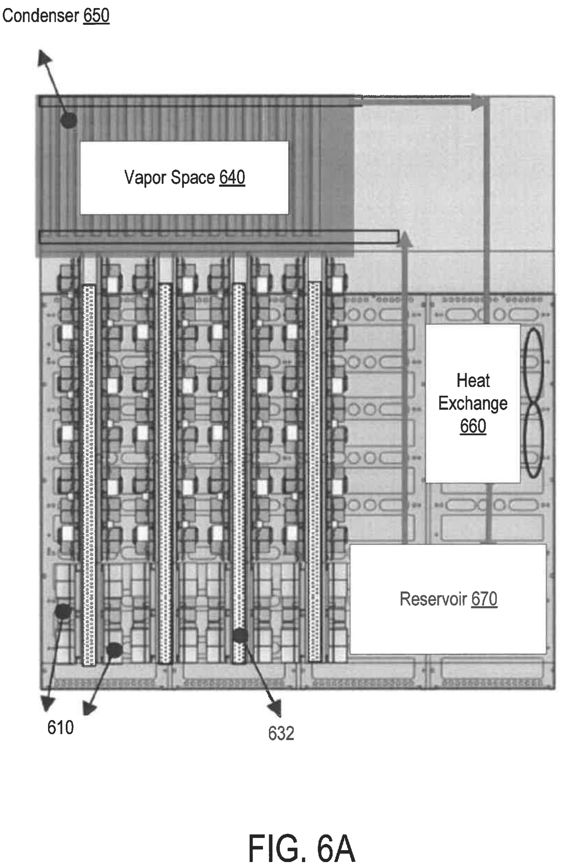

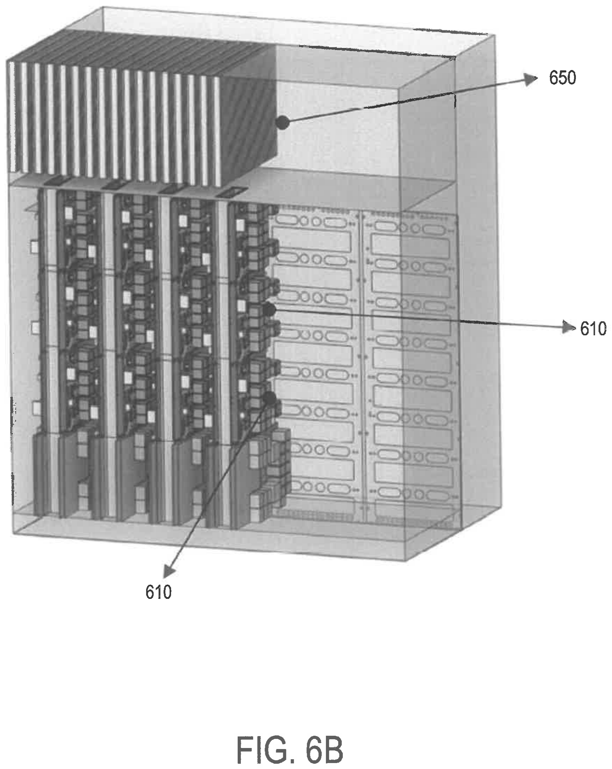

FIGS. 6A and 6B illustrate side and three-dimensional perspective views, respectively, of an embodiment of a two-phase cooling system 600 designed to manage thermal loads within a high-density power configuration. The cooling system 600 can be an embodiment of the cooling systems 100, 300, 400, 401, or 500 of FIGS. 1, 3, 4A, 4B, or 5, respectively.

The cooling system 600 includes a series of power modules 610, each configured with a heat-generating region positioned adjacent to a cooling channel 632. In this example, the power modules 610 are vertically stacked along the channel walls, creating a dense arrangement suitable for high-power applications.

The cooling channels 632 include a dielectric working fluid that absorbs heat from the heat-generating regions of the power modules 610. As the working fluid absorbs heat, it transitions from a liquid phase to a vapor phase. The vaporized fluid rises into a vapor space 640, positioned above the power modules 610, where it is contained before entering the condenser 650.

The condenser 650 is in thermal communication with the vapor space 640 and condenses the vaporized working fluid back into a liquid phase. The condensed fluid then flows back down into a reservoir 670, which is in fluid communication with the cooling channels 632. From the reservoir 670, the working fluid is recirculated back through the channels, creating a continuous cycle of heat absorption, vaporization, condensation, and recirculation within the system.

A heat exchanger 660 is positioned adjacent to the reservoir 670 to dissipate residual heat from the working fluid before it re-enters the cooling channels 632. The heat exchanger 660 helps maintain stable temperatures within the system by allowing the working fluid to return to the channels in a cooled state, ready to absorb additional heat from the power modules 610.

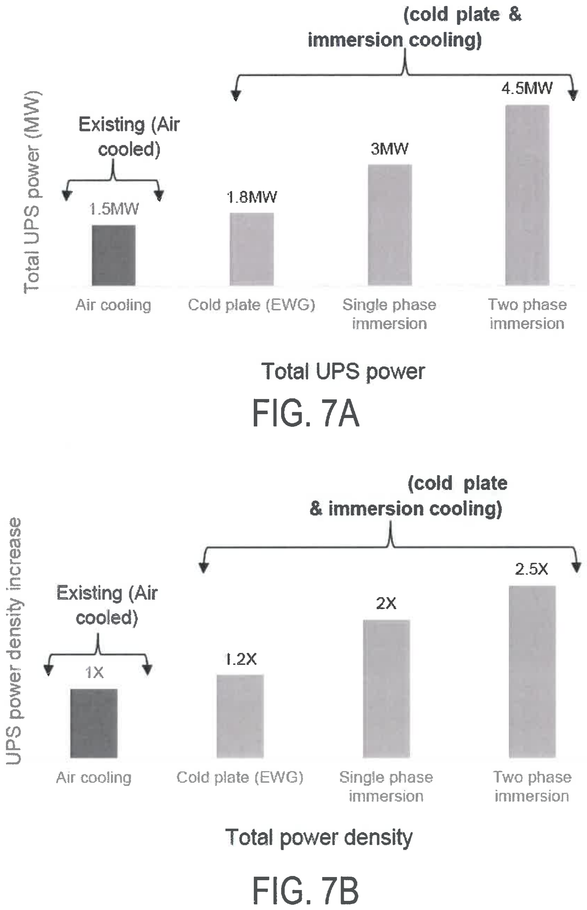

FIG. 7A illustrates example total UPS power capacities achieved through various cooling configurations. The chart compares existing air-cooled systems, which support capacities around 1.5 MW, with example embodiments of the disclosed liquid-based cooling methods. Systems utilizing cold plate cooling with ethylene glycol and water (EGW) fluid can support capacities of approximately 1.8 MW. In some cases, the disclosed single-phase cooling can extend potential capacities to around 3 MW or more, while the disclosed two-phase cooling systems can enable capacities up to approximately 4.5 MW or more. These examples highlight the adaptability of liquid-based cooling approaches to achieve increased power capacities in diverse configurations.

Air-cooled systems serve as a baseline, normalized to 1x. Systems incorporating cold plate cooling show improvements of approximately 1.2x. Single-phase cooling provides further enhancements, achieving around 2x the baseline, while two-phase immersion cooling can support increases of up to approximately 2.5x or more. These results illustrate how liquid-based cooling systems can support higher power densities, offering flexible and scalable solutions for uninterruptible power supply configurations.

### Additional Considerations

Conjunctive language such as the phrase "at least one of X, Y and Z," unless specifically stated otherwise, is otherwise understood with the context as used in general to convey that an item, term, etc. may be either X, Y or Z. Thus, such conjunctive language is not generally intended to imply that certain embodiments require at least one of X, at least one of Y and at least one of Z to each be present.

Conditional language, such as, among others, "can," "could," "might," or "can," unless specifically stated otherwise, or otherwise understood within the context as used, is generally intended to convey that certain embodiments include, while other embodiments do not include, certain features, elements, and/or steps. Thus, such conditional language is not generally intended to imply that features, elements and/or steps are in any way required for one or more embodiments or that one or more embodiments necessarily include logic for deciding, with or without user input or prompting, whether these features, elements and/or steps are included or are to be performed in any particular embodiment.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, or a combination thereof. Additionally, the words "herein," "above," "below," and words of similar import, when used in this application, refer to this application as a whole and not to any particular portions of this application. Where the context permits, words in the above detailed description using the singular or plural number can also include the plural or singular number respectively. The word "or" in reference to a list of two or more items, covers all of the following interpretations of the word: any one of the items in the list, all of the items in the list, and any combination of the items in the list. Likewise, the term "and/or" in reference to a list of two or more items, covers all of the following interpretations of the word: any one of the items in the list, all of the items in the list, and any combination of the items in the list.

Depending on the embodiment, certain operations, acts, events, or functions of any of the algorithms described herein can be performed in a different sequence, can be added, merged, or left out altogether (for example, not all are necessary for the practice of the algorithms). Moreover, in certain embodiments, operations, acts, functions, or events can be performed concurrently, for example, through multi-threaded processing, interrupt processing, or multiple processors or processor cores or on other parallel architectures, rather than sequentially.

Systems and modules described herein can comprise software, firmware, hardware, or any combination(s) of software, firmware, or hardware suitable for the purposes described herein. Software and other modules can reside and execute on servers, workstations, personal computers, computerized tablets, PDAs, and other computing devices suitable for the purposes described herein. Software and other modules can be accessible via local memory, via a network, via a browser, or via other means suitable for the purposes described herein. Data structures described herein can comprise computer files, variables, programming arrays, programming structures, or any electronic information storage schemes or methods, or any combinations thereof, suitable for the purposes described herein. User interface elements described herein can comprise elements from graphical user interfaces, interactive voice response, command line interfaces, and other suitable interfaces.

Further, the processing of the various components of the illustrated systems can be distributed across multiple machines, networks, and other computing resources. In addition, two or more components of a system can be combined into fewer components. Various components of the illustrated systems can be implemented in one or more virtual machines, rather than in dedicated computer hardware systems and/or computing devices. Likewise, the data storage devices shown can represent physical and/or logical data storage, including, for example, storage area networks or other distributed storage systems. Moreover, the connections between the components shown can represent possible paths of data flow, rather than actual connections between hardware. While some examples of possible connections are shown, any of the subset of the components shown can communicate with any other subset of components in various implementations.

Embodiments are also described above with reference to flow chart illustrations and/or block diagrams of methods, apparatus (systems) and computer program products. Each block of the flow chart illustrations and/or block diagrams, and combinations of blocks in the flow chart illustrations and/or block diagrams, can be implemented by computer program instructions. Such instructions can be provided to a processor of a general purpose computer, special purpose computer, specially-equipped computer (for example, comprising a high-performance database server, a graphics subsystem, etc.) or other programmable data processing apparatus to produce a machine, such that the instructions, which execute via the processor(s) of the computer or other programmable data processing apparatus, create means for implementing the acts specified in the flow chart and/or block diagram block or blocks.

These computer program instructions can also be stored in a non-transitory computer-readable memory that can direct a computer or other programmable data processing apparatus to operate in a particular manner, such that the instructions stored in the computer-readable memory produce an article of manufacture including instruction means which implement the acts specified in the flow chart and/or block diagram block or blocks. The computer program instructions can also be loaded onto a computing device or other programmable data processing apparatus to cause a series of operations to be performed on the computing device or other programmable apparatus to produce a computer implemented process such that the instructions which execute on the computer or other programmable apparatus provide steps for implementing the acts specified in the flow chart and/or block diagram block or blocks.

Any patents and applications and other references noted above, including any that can be listed in accompanying filing papers, are incorporated herein by reference. Aspects of the disclosure can be modified, if necessary, to employ the systems, functions, and concepts of the various references described above to provide yet further implementations of the disclosure.

These and other changes can be made in light of the above detailed description. While the above description describes certain examples of the disclosure, and describes the best mode contemplated, no matter how detailed the above appears in text, the disclosure can be practiced in many ways. Details of the system can vary considerably in its specific implementation, while still being encompassed by the disclosure disclosed herein. As noted above, particular terminology used when describing certain features or aspects of the disclosure should not be taken to imply that the terminology is being redefined herein to be restricted to any specific characteristics, features, or aspects of the disclosure with which that terminology is associated. In general, the terms used in the following claims should not be construed to limit the disclosure to the specific examples disclosed in the specification, unless the above detailed description section explicitly defines such terms. Accordingly, the actual scope of the disclosure encompasses not only the disclosed examples, but also all equivalent ways of practicing or implementing the disclosure under the claims.

## Claims

1. A cooling system for a high-density power supply system, the cooling system comprising:
a cooling flow path comprising a plurality of columns configured to hold and circulate a dielectric working fluid in a liquid phase;
a plurality of power modules, each power module comprising a heat-generating region and a control interface portion, wherein the heat-generating regions of the power modules are positioned on opposing sides of each column and directly face the dielectric working fluid within the columns;
a vapor space positioned above the cooling flow path; and
a condenser in thermal communication with the vapor space,
wherein the dielectric working fluid in the cooling flow path absorbs heat from the heat-generating regions of the power modules and transitions from the liquid phase to a vapor phase, wherein vaporized dielectric working fluid rises from the cooling flow path into the vapor space, and the condenser condenses the vaporized dielectric working fluid back into the liquid phase and returns condensed fluid to the cooling flow path.

2. The cooling system of Claim 1, wherein each column includes an internal channel structure configured to guide a flow of the dielectric working fluid within the column.

3. The cooling system of any one of Claims 1 or 2, wherein the power modules are arranged in a stacked configuration along each column, with the heat-generating regions of the power modules aligned in a vertical series on opposing sides of the cooling flow path.

4. The cooling system of any one of Claims 1 to 3, wherein each power module is configured without insulation layers on the heat-generating region, allowing for direct thermal contact between the heat-generating region and the dielectric working fluid within each column.

5. The cooling system of any one of Claims 1 to 4, further comprising a header structure proximate a top of each column, configured to channel vaporized dielectric working fluid from multiple columns into the condenser.

6. The cooling system of any one of Claims 1 to 5, wherein each column comprises an internal cooling volume configured to hold the dielectric working fluid, with the heat-generating regions of the power modules positioned on external surfaces of the column and thermally coupled to the dielectric working fluid within the internal cooling volume.

7. The cooling system of Claim 6, wherein the power modules are mounted along opposing outer surfaces of each column, with the heat-generating regions of the power modules aligned to transfer heat through walls of the column to the dielectric working fluid contained within the internal cooling volume.

8. The cooling system of any one of Claims 1 to 7, wherein the columns are substantially vertically oriented.

9. The cooling system of any one of Claims 1 to 8, wherein the high-density power supply system comprises an uninterruptible power supply (UPS) system.

10. A cooling system for a high-density power supply system, the cooling system comprising:
a cold plate having a fluid inlet and a fluid outlet, the cold plate defining an internal fluid channel configured to circulate a dielectric working fluid;
a plurality of power modules, each power module comprising a heat-generating region and a control interface portion, wherein the heat-generating regions of the power modules are mounted along opposing outer surfaces of the cold plate, with the heat-generating regions aligned to transfer heat through walls of the cold plate to the dielectric working fluid within the internal fluid channel;
a heat exchanger in fluid communication with the working fluid outlet and the working fluid inlet of the cold plate, configured to dissipate heat absorbed by the dielectric working fluid as it circulates through the heat exchanger and returns to the cold plate.

11. The cooling system of Claim 10, wherein the dielectric working fluid comprises a mixture of water and ethylene glycol (EGW).

12. The cooling system of Claim 10, wherein the cold plate is positioned in a horizontal orientation and defines a substantially horizontal flow path for the dielectric working fluid, the cold plate comprising a fluid inlet positioned on one side of the cold plate and a fluid outlet positioned on an opposite side of the cold plate, such that the dielectric working fluid flows laterally across an internal channel of the cold plate in a substantially horizontal direction.

13. The cooling system of Claim 12, wherein power modules are mounted on upper and lower external surfaces of the cold plate, with the heat-generating regions of the power modules in thermal communication with the dielectric working fluid flowing through the cold plate.

14. The cooling system of Claim 10, wherein the cold plate comprises a plurality of individual cold plates arranged in a stacked configuration, each individual cold plate in fluid communication with a common fluid inlet manifold and a common fluid outlet manifold, and wherein power modules are mounted on opposing external surfaces of each individual cold plate, with the heat-generating regions of the power modules in thermal communication with the dielectric working fluid flowing through each cold plate.

15. A cooling system for a high-density power supply system, the cooling system comprising:
a cooling flow path configured to hold and circulate a working fluid to manage a thermal load generated by the power supply system during operation; and
a plurality of power modules, each power module comprising a heat-generating region and a control interface portion, wherein the heat-generating regions of the power modules are mounted on opposing exterior surfaces of the cooling flow path and directly face the cooling flow path, such that each heat-generating region is in thermal communication with the working fluid within the cooling flow path.
